# EUROPEAN PATENT APPLICATION

(11) **EP 0 600 747 A2**
(43) Date of publication of application: **08.06.1994**
(21) Application number: 93309715.6
(22) Date of filing: 03.12.1993
(51) Int. Cl.: G03F 7/039, G03F 7/38, G03F 7/20

(54) **Method for forming a fine pattern**

(30) Priority: 04.12.1992 KR 9223269
(71) Applicant: SAMSUNG ELECTRONICS CO., LTD., Suwon-city, Kyungki-do 441-373 (KR)
(72) Inventor: Kim, Hak, Yangcheon-Gu, Seoul (KR); Kang, Ho-Young, Paldal-Gu, Suwon-City, Kyungki-Do (KR)
(74) Representative: Crawford, Fiona Merle

(57) **Abstract**

A method for forming fine patterns of a semiconductor device uses an electron beam with a low accelerating voltage (1∼5KeV) and a silylating process. A resist is coated on a substrate (11) to form a resist film (12). Using the electron beam (13), portions of the upper surface of the resist film (12) are selectively exposed. Then, the exposed resist film (12) is silylated selectively so as to form a silylation layer (18) on the upper portion of the resist film (12). This resist film (12) is etched using the silylation layer (18) as a mask so as to form the resist pattern (12'). Silicon of the silylation layer (18) at the first stage of the dry etching reacts with oxygen plasma, thereby to form the etching mask (18') composed of SiOₓ. Here, ultra fine patterns (0.1µm) can be manufactured and the throughput of the electron beam lithography is increased.

## Description

The present invention relates to a method for forming a fine pattern of a semiconductor device, and more particularly, to a method for forming an ultra fine pattern using a low accelerating voltage of an electron beam exposure apparatus and a surface image process.

In order to manufacture fine semiconductor circuits, the implantation of impurities is controlled accurately in minute regions of a silicon substrate, and the inter-connection between these regions forms a device and VLSI circuits. Patterns for defining these regions are manufactured according to a lithography process. That is, the lithography process includes the steps of coating a resist on the surface of a wafer substrate, selectively exposing the coated resist to ultraviolet rays, electron rays, or X-rays and then developing the exposure. Here, the remaining resist protects the substrate covered by the resist, while various additive or subtractive processes are performed on the exposed substrate.

As semiconductor devices acquire greater packaging density, continued development has proceeded with respect to lithography processing for manufacturing fine resist patterns with critical dimensions, i.e., those below sub-micron.

Particularly, in order to reach the megabit stage, the conventional single layer resist has turned out to be unsuitable for manufacturing patterns of sub-micron scale.

The resolution on a planar substrate is determined by the lithography contrast of the resist and the light exposure contrast. Accordingly, in order to manufacture the micron-scale pattern and the sub-micron-scale pattern with high resolution, a good exposure apparatus should be used as well as high-contrast resists. In this case, the difference of the exposure dosage which is in accordance with the optical absorbance of the resist according to the difference of the resist thickness, and the inherent factors of optical lithography such as the reflectance from the substrate, the optical scattering etc., are factors which lower resolution. Besides the problem of low resolution, thermal stability and resistance against dry etching are also necessary characteristics. In addition, the resist should have a thickness of at least 1µm.

In order to solve the above-mentioned problems, a multi-layer resist system has been suggested and, using a triple-layer resist structure, has achieved good results. However, this multi-layer system not only involves complicated processing but also a film and intermediate layer thereof are easily stressed during a baking process. Also, a thin and uniform resist film without pin holes is difficult to form by coating the resist.

To reduce the complexity of the multi-layer system, a double-layer structure including silicon-containing resist has been developed. However, the amount of silicon in the resist should be more than 10%, which lowers the physical and chemical properties of the resist. Consequently, the double-layer structure is rarely used nowadays.

A diffusion-enhanced silylated resist (DESIRE) process which includes both the functionality of the multi-layer and the simplicity of the single layer, has been proposed and is being regarded as a preferable solution (see F. Coopmans and B. Roland, Solid State Technology, June 1987, pp 93-99). Silylation is a process whereby silicon is incorporated into a resist polymer by exposing the material to a gaseous or liquid-silicon-containing compound, such as hexamethyldisilazane (HMDS) or Tetramethyldisilazane(TMDS), at a high temperature (100-200°C). The DESIRE process is characterized in that the latent optical image is transformed into a latent silicon image by a highly selective gaseous silylation. This silicon image is used to produce a relief image by dry etching in oxygen.

Though fine patterns can be formed by the above DESIRE process, several problems exist. It is difficult to control the reaction because the silylation reaction is carried out in a gaseous phase and this makes it difficult to form an uniform silylation layer on the surface portion of the resist. As the width of the pattern reduces, a resist residue is undesirably formed around the pattern owing to the undesirable parasitic exposure due to the diffraction of the light. Moreover, since the molecules of the silylating agent penetrates into the resist layer and reacts with the molecules of the resist, the resulting swelling phenomena makes it difficult to form a desired pattern, and controlling the resist stripping is very difficult.

Also, when forming patterns using ultraviolet rays and deep ultraviolet rays according to a conventional method, the resolution of the optical lithography is limited somewhat less than 1µm. To form patterns below sub-micron scale, other lithography methods are proposed, that is, electron beam lithography, ion beam lithography and X-ray lithography.

Electron beam lithography (often referred to as EBL) is a method which forms the circuit pattern by using a focussed electron beam. Here, using the electron beam, the patterns below sub-micron scale can be directly written on the resist film formed on the surface of the semiconductor wafer or on the resist film formed on the surface of photo masks during a general photolithography process. Patterns formed in the layout step are registered in a computer as image patterns and electron beam can be controlled by the electron deflecting plate according to the signals from the computer. Accordingly, EBL provides the ability to produce features less than 1µm directly on the wafer without the use of a mask. The above EBL method is slower than the conventional photolithography method. However, since very accurate layer-to-layer registration can be accomplished using this method, features as small as 0.1µm can be made and fine patterns can be formed. For these reasons, attempts to put the EBL method into practice are still being made.

In the lithography process for forming fine patterns using the conventional electron beam exposure apparatus, more than 10KeV of accelerating voltage of electron beam (typically 20KeV) is adapted in order to enhance the profiles of the resist patterns. For good profiles of the resist patterns, the resist is coated thinly.

FIGs. 1 to 3 of the accompanying drawings are cross-sectional views for explaining the method for forming patterns using the electron beam lithography adapting the conventional high accelerating voltage.

A resist is coated on the surface of a semiconductor substrate 1 to form a resist film 2 (FIG.1). An electron beam 3 with a high accelerating voltage is selectively scanned on the surface of resist film 2, to expose the resist layer partially (FIG.2). Then, the resultant is developed to form a resist pattern (FIG.3).

As described above, in the conventional electron beam lithography, when the accelerating voltage of the electron beam is more than 20KeV, and a thin (1µm) resist film is employed, patterns having excellent profiles and high resolution are acquired.

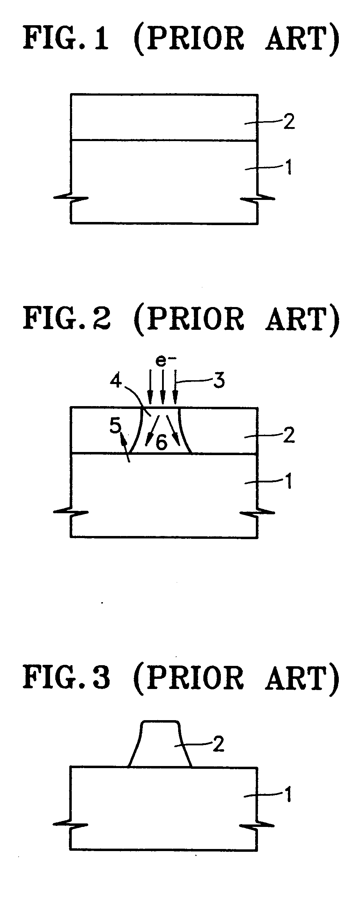

However, when more than 20KeV of accelerating voltage is employed, the influences of forward scattering (reference numeral 6 in FIG.2) and back scattering (reference numeral 5 in FIG.2) of the electron beam are relatively great. As a result, pattern formation is difficult. More particularly, as scattering occurs ranging over several microns, when exposing compactly formed patterns, electrons are injected into adjacent patterns thereby exposing the unwanted portion of the resist layer. This is referred to as the proximity effect.

Also, thermal deformation of the resist film is generated in the surface portion thereof due to the high accelerating voltage, which creates defects in the resist pattern. Further, for reducing the proximity effect, the size of a pattern is controlled properly or the exposure time is controlled, according to the sizes of patterns or to the adjacent patterns. This increases necessary data for operating the exposure system and CPU time thereof is increased. As a result, the throughput of the system is lowered.

Still further, the method for forming patterns using the low accelerating voltage is disclosed in Jpn. J. Appl. Phys. Vol.31 (1992), part2, No. 6A, pp.L774∼L746). However, according to this method, electron penetration depth is shallow, so that in case that the thickness of a resist film is more than 0.5µm, the formation of patterns can not be accomplished.

Accordingly, in order to solve the above described problems, an object of the present invention is to provide a method for forming fine patterns, which can manufacture satisfactory resist patterns from resist with a thickness of 1µm, using the electron beam with a low acceleration voltage.

According to the present invention there is provided a method for forming patterns, which includes the steps of coating a resist on a substrate to form a resist film, exposing selectively the upper surface portions of the resist film using an electron beam with a low accelerating voltage, silylating the exposed resist film to form selectively a silylation layer on the upper portions of the resist film, and etching the resist film using the silylation layer as a mask.

The accelerating voltage of the electron beam is preferably from 1KeV to 5KeV.

A silylating agent in the silylation step may include: hexamethyldisilazane, tetramethyldisilazane, dimethylsilyldimethylamine, dimethylsilyldiethylamine, trimethylsilyldimethylamine, trimethylsilyldiethylamine, dimethylaminotrimethylsilane, diethylaminotrimethylsilane, bis(dimethylamino)dimethylsilane, bis(dimethylamino)methylsilane, octamethylcyclotetrasilazane, hexamethylcyclotrisilazane, dichlorooctamethylcyclotetrasiloxane, dichlorodimethyldiphenyldisiloxane, tetramethyldisilazacyclopentane, tetramethyl-bis(N,N-dimethylamino)disilethylene, bis(trimethylsilyl)acetamide, or other organometallc reagents. The above silylating agents may be used alone or in a mixture thereof. In the above silylation step, the above silylating agent in a gaseous state or aqueous state is injected onto the surface of the resist film, such that the above resist film is treated. Then, using the above silylation layer as an etching mask in the dry etching process using oxygen plasma, CH₄+O₂ plasma or a plasma mixture thereof, etching the resist film is carried out, and thereby patterns are manufactured.

The above method of the present invention may be accomplished according to a negative tone method wherein the exposed portion of the resist film is selectively silylated, or according to a positive tone method wherein the unexposed portion of the resist layer is selectively silylated. As for the resist, a negative type electron beam resist is preferably employed.

According to embodiments of the present invention, due to using the electron beam having less than 5KeV of accelerating voltage, fine patterns can be transferred on the surface of the resist film, and the forward scattering and the back scattering of the electron beam can be reduced remarkably, and thereby the patterns of ultra-micron scale (less than 10nm of patterns) may be manufactured.

Embodiments of the present invention will now be described by way of example with reference to the accompanying drawings in which:
FIGs.1 to 3 are the cross-sectional views for explaining a method for forming patterns according to a conventional electron beam lithography using a high accelerating voltage;

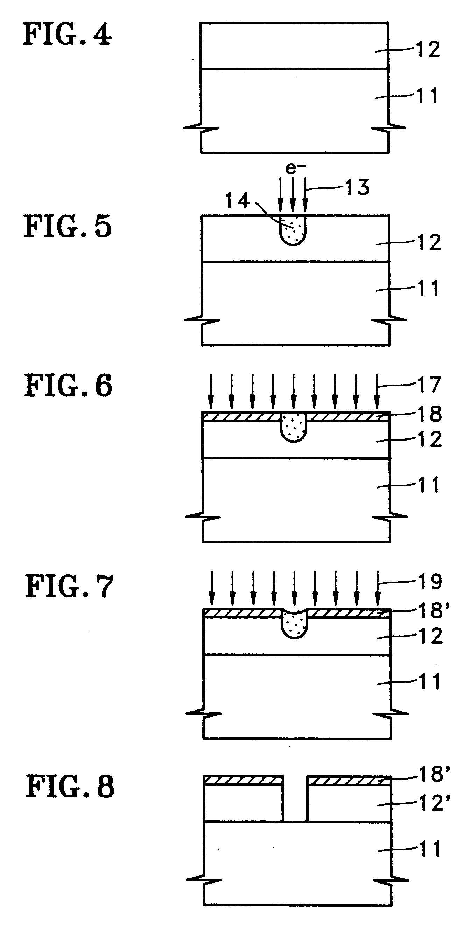

FIGs.4 to 8 are the cross-sectional views showing a method for forming patterns according to one embodiment of the present invention; and

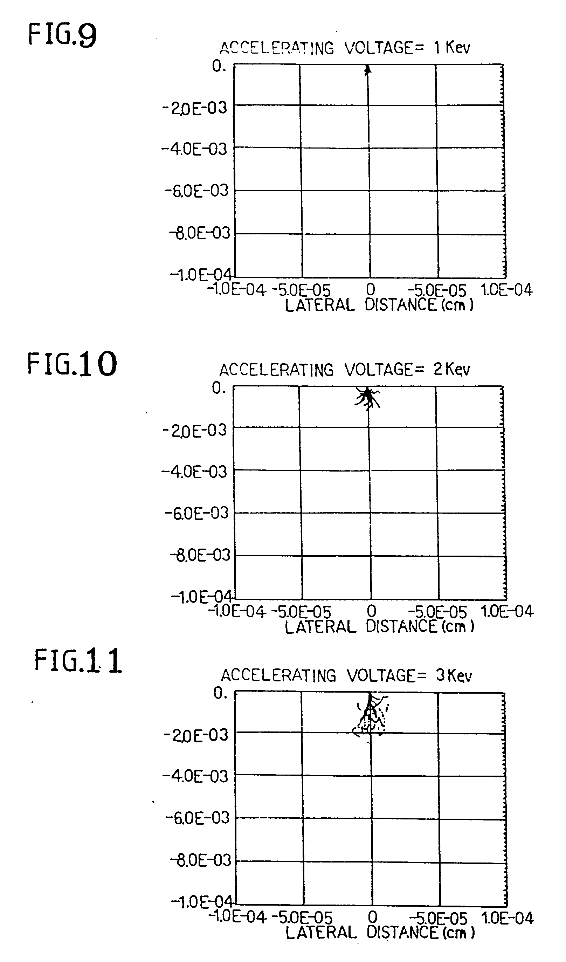

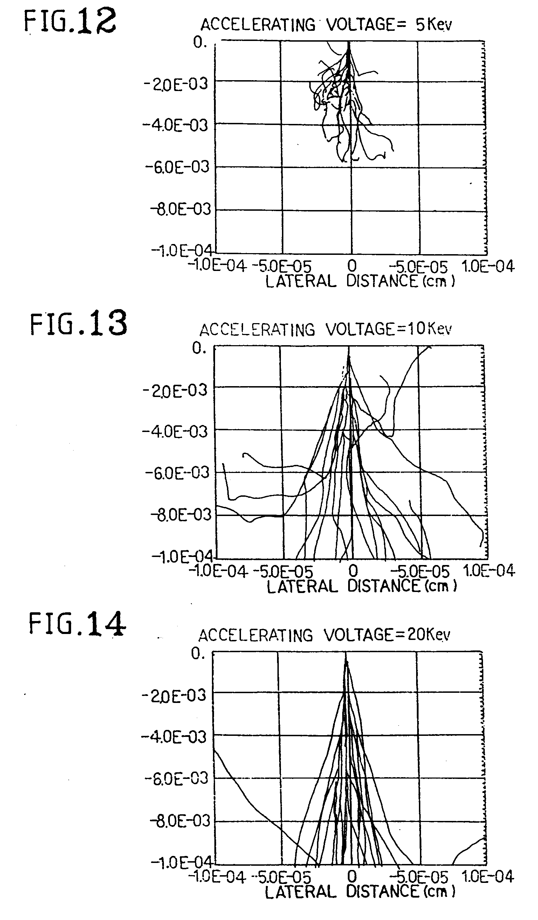

FIGs.9 to 14 are simulated graphs showing the loci (depth vs. lateral distance) of electrons in the resist film, according to six different accelerating voltages of an electron beam, respectively.

Hereinafter, embodiments of the present invention is described in more detail.

According to the present invention, a resist is coated on a semiconductor substrate so as to form a resist film, and the upper surface of the above resist film is selectively exposed using an electron beam with a low accelerating voltage. Then, after the exposed resist film is silylated so that the silylation layer is selectively formed on a portion of the upper surface of the resist film, etching the resist film is accomplished by using the silylation layer as a mask, thereby to form patterns.

In the electron beam exposure process of the present invention, the accelerating voltage of the above electron beam preferably ranges from 1KeV to 5KeV.

FIGs.9 to 14 are simulated graphs showing the loci (depth vs. lateral distance) of electrons in the resist film, according to six different accelerating voltages of an electron beam, respectively. The graphs represent the case where the electron beam is delivered at accelerating voltages of 1keV, 2KeV, 3KeV, 5KeV, 10KeV and 20KeV onto a resist film whose thickness is 1µm. Here, the vertical axis corresponds to the depth of the resist film, while the horizontal axis corresponds to a lateral distance starting from the point where the electron beam is scanned. The fine lines represent the loci of electrons.

As known from FIGs.9 to 14, if the accelerating energy of the electron beam is more than 5KeV, forward scattering and back scattering of the electron beam is generated, so that fine patterns are difficult to manufacture. Also, if the accelerating energy of the electron beam is less than 1KeV, the exposure dosage is so small that the silylation layer is difficult to form. Therefore, as described above, the present invention preferably accomplishes the beam exposing process using a low accelerating voltage, ranging from 1KeV to 5KeV and preferably between 3KeV and 5KeV.

For accelerating voltages of less than 5KeV, the forward scattering and the back scattering of electron beam are reduced remarkably, and the exposure can be carried out with great precision on the surface of the resist. Accordingly, ultra fine patterns (100nm) can be manufactured.

However, when the resist film is exposed using an electron beam with a low accelerating voltage, since the injecting depth of the electron beam is very shallow, patterns cannot be manufactured using the resist film having a thickness of more than 0.5µm. Accordingly, the present invention forms the silylation layer in such a way that the chemical reaction occurs selectively on portions of the exposed resist film by the silylation process, i.e., the surface imaging process while adapting the low accelerating voltage of the electron beam.

The above process wherein the resist film is selectively silylated to form a silylation layer, uses a silicon-containing compound or organo-metallic reagent as the silylating agent to be injected onto the surface of the above resist. As this silylating agent, hexamethyldisilazane, tetramethyldisilazane, dimethylsilyldimethylamine, dimethylsilyldiethylamine, trimethylsilyldimethylamine, trimethylsilyldiethylamine, dimethylaminotrimethylsilane, diethylaminotrimethylsilane, bis(dimethylamino)dimethylsilane, bis(dimethylamino)methylsilane, octamethylcyclotetrasilazane, hexamethylcyclotrisilazane, dichlorooctamethylcyclotetrasiloxane, dichlorodimethyldiphenyldisiloxane, tetramethyldisilazacyclopentane, tetramethyl-bis(N,N-dimethylamino)disilethylene, bis(trimethylsilyl)acetamide, or other organometallic reagents may be included. The above silylating agent, in a gaseous or aqueous state, is injected onto the surface of the resist film so as to treat the film, which accomplishes the silylating process.

In the present invention, the resist patterns are formed by dry etching the above resist layer using the above silylation layer as an etching mask. The dry etching process is preferably carried out using O₂ plasma, CH₄+O₂ plasma or a plasma mixture thereof. The method for developing the resist film using the oxygen plasma for manufacturing the resist patterns is disclosed in U.S. Patent No. 4,657,845.

The silylation layer formed by the above silylation produces a mask layer comprised of SiOₓ, resulting from the reaction with the O₂ plasma during a dry-etching development process, so as to impart resistive properties to the oxygen plasma. Accordingly, this silylation layer can act as an etching mask in the following dry etching process for manufacturing patterns.

The sensitivity of the resist is inversely proportional to the accelerating voltage. Accordingly, fine patterns can be manufactured at a low accelerating voltage, independent of the injecting depth of the electron beam.

FIGs.4 to 8 illustrate a method for manufacturing fine patterns according to one embodiment of the present invention.

FIG.4 illustrates a step of coating a resist on the surface of a semiconductor substrate 11. On the surface of semiconductor substrate 11, a negative chemical amplification type of electron beam resist (for example; SAL-601ER7, trade name of Shipley Co., Ltd), which is a resist able to be exposed by electron beam, is coated to a thickness of 0.7µm, such that a resist film 12 is formed.

FIG.5 illustrates a step of exposing resist film 12. By selectively exposing resist film 12 using an electron beam 13 having a 3KeV accelerating voltage, resist film 12 is defined into an exposed region 14 and an unexposed region.

FIG.6 illustrates a step of selectively silylating the surface portion of the selectively exposed resist film thereby to form a silylation layer 18. Tetramethyldisilazane (TMDS) 7 is injected in a gaseous state onto the surface of resist film 12. A chemical reaction occurs on the surface portion of the unexposed region 14 of resist film 12, such that silylation layer 18 is formed.

FIG.7 illustrates a step of transforming silylation layer 18 into a mask layer 18' at the first stage of the dry etching process. If the dry etching of resist film 12 where silylated layer 18 is formed, is performed in the presence of O₂ plasma 19, the partially etching of the exposed portion is accomplished. However, silylation layer 18 reacts with O₂ plasma in the portion where silylation layer 18 is formed, so as to produce mask layer 18' comprised of SiOₓ.

FIG.8 illustrates a step of performing the dry etching to form resist pattern 12'. As the above dry etching process is proceeded, mask layer 18' serves as the etching mask, so that a portion of the exposed surface of resist film 12 and the lower remaining resist thereof are etched, thereby to form resist patterns.

According to the method for forming fine patterns of the present invention, a negative pattern (hole or space pattern) equaling the size of the electron beam can be manufactured.

The above embodiment adapts a negative resist. A positive resist may be used as well; in which case, a relief pattern (line or dot pattern) can be manufactured.

According to the method for manufacturing patterns of the present invention, due to the use of the low accelerating voltage and the surface imaging process, the proximity effect resulting from an electron beam having the conventional high accelerating voltage can be prevented. Also, data need not be increased to compensate for the proximity effect when an electron beam having a high accelerating voltage is used, so that the throughput is increased.

While the present invention has been particularly shown and described with reference to particular embodiments thereof, it will be understood by those skilled in the art that various changes in form and detail may be effected therein without departing from the scope of the present invention.

## Claims

1. A method for forming patterns comprising the steps of:
coating a resist on a substrate (11) to form a resist film (12);
exposing a portion of the upper surface of said resist film (12), using an electron beam (13) with an accelerating voltage of less than 10 KeV;
silylating said exposed resist film (12) selectively to form the silylation layer (18) on the upper portion of said resist film; and
etching said resist film (12), using said silylation layer (12) as a mask.

2. A method for forming patterns as claimed in claim 1, wherein the accelerating voltage of said electron beam (12) is in the range from 1KeV to 5KeV.

3. A method for forming patterns as claimed in claim 1 or 2, wherein the accelerating voltage of said electron beam is in the range from 3KeV to 5KeV.

4. A method for forming patterns as claimed in claim 1, 2 or 3 wherein said silylating step is performed using as a silylating agent at least one selected from the group consisting of hexamethyldisilazane, tetramethyldisilazane, dimethylsilyldimethylamine, dimethylsilyldiethylamine, trimethylsilyldimethylamine, trimethylsilyldiethylamine, dimethylaminotrimethylsilane, diethylaminotrimethylsilane, bis(dimethylamino)dimethylsilane, bis(dimethylamino)methylsilane, octamethylcyclotetrasilazane, hexamethylcyclotrisilazane, dichlorooctamethylcyclotetrasiloxane, dichlorodimethyldiphenyldisiloxane, tetramethyldisilazacyclopentane, tetramethyl-bis(N,N-dimethylamino)disilethylene and bis(trimethylsilyl)acetamide.

5. A method for forming patterns as claimed in claim 4, wherein in said silylating step, said silylating agent is injected in a gaseous state onto the surface of said resist film (12).

6. A method for forming patterns as claimed in any preceding claim, wherein etching said resist film (12) is performed by a dry etching method using O₂ plasma.

7. A method for forming patterns as claimed in any of claims 1 to 5 wherein etching said resist film (12) is performed by a dry etching method using CH₄+O₂ plasma.

8. A method for forming patterns as claimed in any of claims 1 to 5, wherein etching said resist film (12) is accomplished by a dry etching method using a mixture of O₂ plasma and CH₄+O₂ plasma.

9. A method for forming patterns as claimed in any preceding claim, wherein said resist is a negative-type electron beam resist.
